(19) Europäisches Patentamt
European Patent Office
Office européen des brevets

(11) **EP 2 216 906 A1**

(12) **DEMANDE DE BREVET EUROPEEN**

(43) Date de publication:
**11.08.2010 Bulletin 2010/32**

(51) Int Cl.:
*H03M 1/16* (2006.01)    *H03M 1/18* (2006.01)

(21) Numéro de dépôt: **10152991.5**

(22) Date de dépôt: **09.02.2010**

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**
Etats d'extension désignés:
**AL BA RS**

(30) Priorité: **10.02.2009  FR 0950802**

(71) Demandeur: **STMicroelectronics (Grenoble 2)
SAS
38000 Grenoble (FR)**

(72) Inventeurs:
• **Gicquel, Hugo**
  **38000 Grenoble (FR)**
• **Minot, Sophie**
  **38100 Grenoble (FR)**
• **Sabut, Marc**
  **38320 Eybens (FR)**

(74) Mandataire: **Zapalowicz, Francis
Casalonga & Partners
Bayerstrasse 71/73
80335 München (DE)**

(54) **Convertisseur analogique-numérique à architecture pipeline associé à un amplificateur à gain programmable**

(57)    Dispositif, comprenant un amplificateur à gain programmable et un convertisseur analogique-numérique à architecture pipeline comportant plusieurs étages ; le premier étage (ET1) du convertisseur analogique-numérique (DCAN) incorpore l'amplificateur à gain programmable (AMPP) ainsi qu'un circuit de conversion analogique-numérique à seuil programmable (CAN).

FIG.3

**Description**

L'invention concerne la conversion de signaux, et plus particulièrement les convertisseurs analogiques-numériques à architecture pipeline associés à un amplificateur à gain programmable.

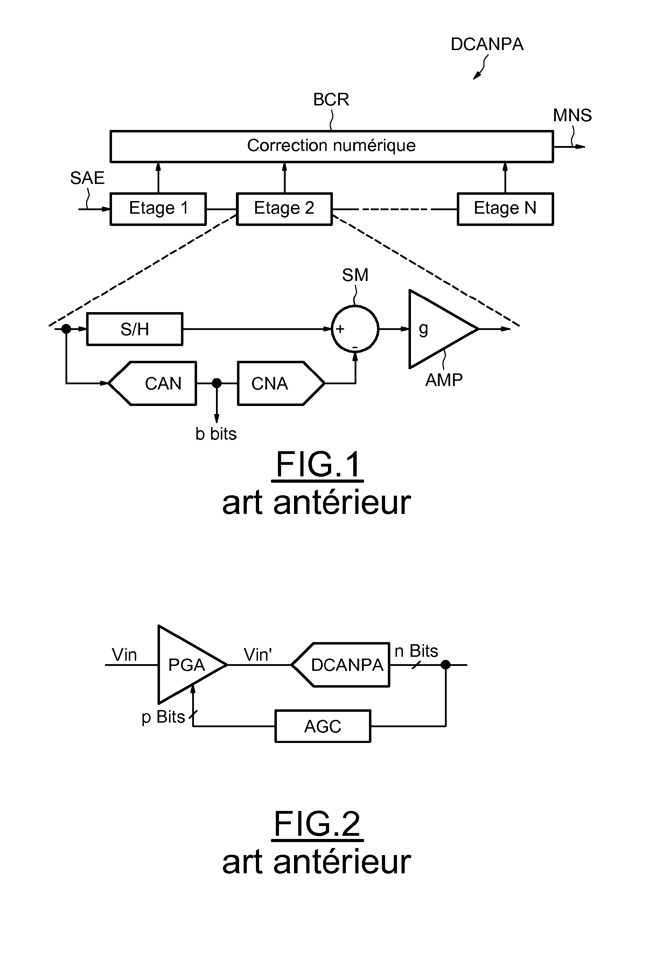

Comme illustré de façon schématique sur la figure 1, un convertisseur analogique-numérique à architecture pipeline DCANPA comporte plusieurs étages (ici N étages) dont chacun possède généralement une résolution assez faible (de 1 à 3 bits en général).

Le premier étage reçoit un signal analogique SAE et le convertisseur DCANPA délivre en sortie un mot numérique correspondant MNS.

Chacun des étages possède un échantillonneur-bloqueur S/H pour échantillonner le signal issu de l'étage précédent, signal communément désigné par l'homme du métier sous le vocable « résidu ».

Chaque étage comporte par ailleurs un circuit de conversion analogique-numérique CAN délivrant b bits, et suivi d'un circuit de conversion numérique-analogique. La sortie du convertisseur numérique-analogique CNA est soustraite au signal issu de l'échantillonneur-bloqueur S/H puis amplifiée dans un amplificateur AMP à gain fixe g.

Les b bits de chaque étage subissent une correction numérique dans un bloc BCR pour former le mot numérique de sortie MNS. Ce type de convertisseur à architecture pipeline a notamment l'avantage de présenter une vitesse d'échantillonnage indépendante du nombre d'étages utilisés et une bonne tolérance vis-à-vis des décalages (offsets) des comparateurs des circuits CAN.

Dans les systèmes de conversion de données, on associe généralement à ce type de convertisseur analogique-numérique un amplificateur à gain programmable PGA, disposé avant l'entrée du convertisseur analogique numérique, ce qui permet d'ajuster l'amplitude du signal analogique d'entrée (tension Vin par exemple), comme illustré sur la figure 2.

L'amplificateur à gain programmable PGA est par exemple contrôlé par des moyens de contrôle automatique de gain AGC classiques et connus en soi.

Un inconvénient majeur d'une telle réalisation réside dans le fait que l'amplificateur à gain programmable PGA doit être conçu pour introduire un bruit négligeable et une distorsion négligeable dans le signal. Sinon, la conversion analogique-numérique effectuée dans le convertisseur DCANPA sera affecté d'une erreur.

En outre, par exemple dans les systèmes à temps continu basés sur des rapports de résistance, le bruit est fonction de la valeur de la résistance. En conséquence, la valeur de résistance doit être diminuée pour obtenir un faible bruit, ce qui implique une forte augmentation de la consommation électrique.

Selon un mode de réalisation, il est proposé un dispositif comprenant un amplificateur à gain programmable et un convertisseur analogique-numérique à architecture pipeline offrant des contraintes relâchées sur le bruit et la distorsion par rapport à un amplificateur à gain programmable classique associé de façon classique à ce type de convertisseur analogique-numérique.

Selon un mode de réalisation, il est également proposé une réalisation réduisant d'une façon sensible la surface occupée et la consommation électrique.

Selon un aspect, il est ainsi proposé de combiner l'amplificateur à gain programmable avec le convertisseur analogique-numérique à architecture pipeline. Et, lorsque le convertisseur analogique-numérique est cadencé au rythme d'un signal d'horloge, la quantification et l'amplification/atténuation sont effectuées au cours d'une même période du signal d'horloge. De ce fait, les contraintes sur le bruit et la distorsion sont relâchées par rapport à un amplificateur à gain programmable classique disposé à l'extérieur du convertisseur analogique-numérique.

La quantification et l'amplification/attenuation sont programmables et programmées par des signaux de contrôles externes au convertisseur analogique-numérique et obtenus à partir du signal de sortie du convertisseur analogique-numérique.

Ainsi, selon un autre aspect, il est proposé un dispositif comprenant un amplificateur à gain programmable et un convertisseur analogique-numérique à architecture pipeline comportant plusieurs étages.

Selon une caractéristique générale de cet autre aspect, le premier étage du convertisseur analogique-numérique incorpore l'amplificateur à gain programmable ainsi qu'un circuit de conversion analogique-numérique à seuil programmable.

Il est ainsi proposé, par exemple, de modifier le premier étage du convertisseur analogique numérique à architecture pipeline de façon à lui incorporer l'amplificateur à gain programmable.

Selon un mode de réalisation, l'amplificateur à gain programmable comprend un amplificateur dont la sortie est rebouclée sur une première entrée de cet amplificateur par l'intermédiaire d'un premier circuit capacitif commuté ; ce premier circuit capacitif commuté comporte un premier bloc capacitif et un deuxième bloc capacitif de valeur capacitive programmable ; le premier circuit capacitif commuté est par ailleurs couplé à l'entrée du premier étage ; par ailleurs, le circuit de conversion analogique-numérique à seuil programmable est couplé à l'entrée du premier étage et comporte des moyens de seuillage programmables configurés pour définir différents seuils programmables correspondant aux différents gains programmables de l'amplificateur.

Le deuxième bloc capacitif présentant une valeur capacitive programmable peut comporter, par exemple, plusieurs branches capacitives en parallèle, chaque branche capacitive comportant un réseau capacitif en série avec un commutateur commandable.

Les moyens de seuillage programmables peuvent comporter par exemple un pont diviseur de tension programmable incluant un réseau résistif couplé à une tension de référence et à plusieurs commutateurs sélectivement commandables.

Selon un mode de réalisation, le premier étage du convertisseur analogique-numérique comporte en outre un circuit de conversion numérique-analogique, couplé à la sortie du circuit analogique-numérique, et configuré pour délivrer sélectivement une valeur de tension prise parmi un jeu de valeurs de référence indépendantes des valeurs des gains programmables. Le premier étage du convertisseur comporte en outre un deuxième circuit capacitif commuté couplé à la sortie du circuit analogique-numérique et dont la valeur est proportionnelle (par exemple égale dans le cas d'un étage 1,5 bit) à la valeur capacitive du premier bloc capacitif.

Un tel mode de réalisation permet d'une part, de ne pas programmer le jeu de valeurs de référence en fonction des gains programmables et d'implémenter de façon très simple l'opération de soustraction effectuée au sein du premier étage.

Comme indiqué ci avant, lorsque le circuit de conversion analogique-numérique du premier étage est un circuit 1,5 bit, la valeur capacitive du deuxième circuit capacitif commuté, qui est couplée à la sortie du circuit de conversion numérique-analogique, est avantageusement égale à la valeur capacitive du premier bloc capacitif.

Le dispositif peut également comprendre, en outre, des moyens de contrôle configurés pour délivrer des signaux de contrôles destinés à programmer une valeur de gain et une valeur de seuil. Ces moyens de contrôle sont avantageusement externes au convertisseur analogique-numérique et sont par exemple réalisés par une boucle d'asservissement numérique externe de structure classique et connue en soi.

D'autres avantages et caractéristiques de l'invention apparaîtront à l'examen de la description détaillée de modes de réalisation et de mise en oeuvre, nullement limitatifs, et des dessins annexés sur lesquels :

- les figures 1 et 2, déjà décrites, illustrent schématiquement des réalisations de l'art antérieur ;
- la figure 3 illustre schématiquement un mode de réalisation d'un dispositif selon l'invention ;
- les figures 4 à 10 illustrent schématiquement mais plus en détails des exemples de réalisation et de fonctionnement du premier étage du convertisseur analogique-numérique du dispositif de la figure 3 ; et,
- les figures 11 et 12 illustrent schématiquement des exemples de réalisation et de fonctionnement d'une partie d'un autre étage du convertisseur analogique-numérique de la figure 3.

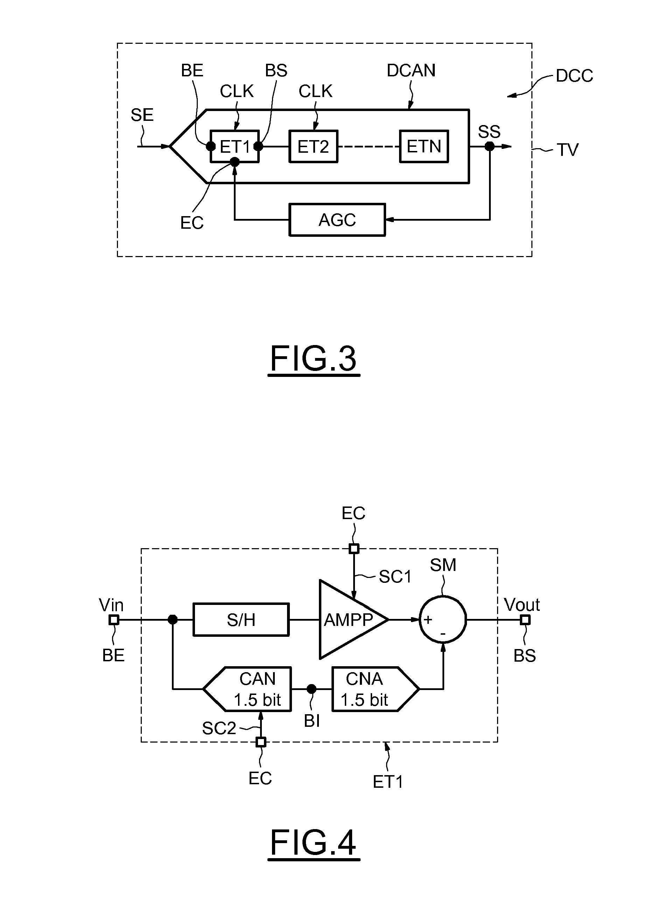

Sur la figure 3, la référence DCC désigne un dispositif comportant un convertisseur analogique-numérique DCAN du type à architecture pipeline, comportant plusieurs étages ET1, ...ETN. Le convertisseur DCAN reçoit un signal analogique SE et délivre un signal numérique de sortie SS.

Par ailleurs, comme on le verra plus en détails ci-après, le premier étage T1 du convertisseur DCAN incorpore un amplificateur à gain programmable ainsi qu'un circuit analogique-numérique à seuil programmable. Aussi, est-il prévu avantageusement des moyens de contrôle aptes à programmer les valeurs de gains et des seuils correspondants. Ces moyens de contrôle AGC, externes au convertisseur DCAN, sont de type classique et connu en soi, comportant par exemple une boucle d'asservissement numérique, et sont connectés entre la sortie SS et le premier étage ET1.

L'étage ET1 comporte une borne d'entrée BE, une borne de sortie BS et une ou plusieurs entrées de commande EC destinées à recevoir les signaux de contrôle délivrés par les moyens AGC.

Par ailleurs, chaque étage est cadencé au rythme d'un signal d'horloge CLK. En fait, généralement, si l'étage de rang « i » est cadencé au rythme du signal d'horloge CLK, l'étage i+1 est cadencé au rythme du même signal d'horloge CLK mais en utilisant le signal opposé $\overline{CLK}$.

A titre indicatif et non limitatif, le dispositif DCC peut être incorporé par exemple au sein d'un téléviseur ou d'un ordinateur, le signal SE pouvant être alors par exemple un signal de télévision.

Sur la figure 4, est illustrée de façon plus détaillée et toujours schématique, l'architecture interne du premier étage ET1 du convertisseur DCAN de la figure 3.

Ce premier étage comporte ici un échantillonneur-bloqueur S/H connecté à la borne d'entrée BE. Entre cet échantillonneur-bloqueur S/H et l'entrée « + » d'un sommateur SM, est disposé un amplificateur à gain programmable AMPP configuré pour recevoir un signal de contrôle SC1 à partir de l'entrée de commande EC. Ce signal de contrôle SC1 est, comme on le verra plus en détail ci-après, destiné à sélectionner une valeur de gain parmi un ensemble de valeurs possibles.

Le premier étage ET1 comporte également un circuit analogique-numérique CAN dont l'entrée est reliée à la borne d'entrée BE et dont la sortie BI délivre un ou plusieurs bits (selon la résolution de l'étage de conversion analogique-numérique). Ce circuit analogique-numérique est à seuil programmable et est destiné à recevoir un signal de contrôle SC2 de l'entrée de commande SC, de façon à sélectionner les seuils de comparaison correspondant aux valeurs des gains sélectionnés.

Cet étage de conversion analogique-numérique CAN commande un étage de conversion numérique-analogique CNA dont la sortie est reliée à l'entrée « - » du sommateur SM.

La sortie du sommateur SM est connectée à la sortie BS de l'étage ET1.

Dans l'exemple décrit ici, qui n'est en aucun cas limitatif, le premier étage ET1 est un étage 1,5 bit, selon une dénomination habituellement utilisée par l'homme du métier. Plus précisément, la sortie BI délivre deux bits mais, au lieu que ces deux bits définissent quatre valeurs logiques, ils n'en définissent que trois, à savoir les valeurs 00, 01 et 10. C'est la raison pour laquelle on parle d'un étage 1,5 bit.

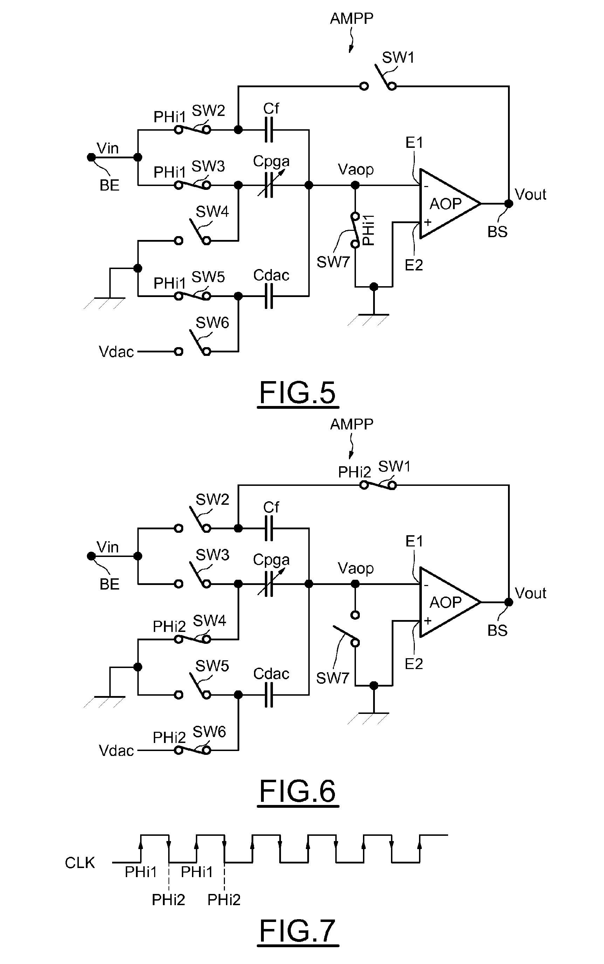

Comme illustré sur la figure 5, l'amplificateur à gain programmable AMPP comporte un amplificateur AOP possédant une première entrée E1 (entrée « - ») et une deuxième entrée E2 (entrée « + »). L'entrée E2 est couplée à la masse. La sortie BS de l'amplificateur AOP, qui est en fait la borne de sortie BS de l'étage ET1, est rebouclée sur l'entrée E1 par l'intermédiaire d'un premier circuit capacitif commuté.

Ce premier circuit capacitif commuté comporte un premier bloc capacitif, ici un condensateur Cf, et un deuxième bloc capacitif de valeur capacitive programmable Cpga.

Le premier circuit capacitif commuté est couplé à la borne d'entrée BE du premier étage par l'intermédiaire de deux commutateurs SW2, SW3. La sortie BS de l'amplificateur AOP est connectée au premier bloc capacitif Cf, entre ce premier bloc capacitif CF et le commutateur SW2, par l'intermédiaire d'un commutateur SW1.

Par ailleurs, l'autre borne du premier bloc capacitif Cf et la borne correspondante du bloc capacitif Cpga sont connectées ensemble à l'entrée E1 de l'amplificateur AOP.

Cette entrée E1 est par ailleurs également connectée à la masse par l'intermédiaire d'un commutateur SW7.

Le bloc capacitif Cpga est également connecté à la masse par l'intermédiaire d'un commutateur SW4.

Outre ce premier circuit capacitif commuté, formé des deux blocs capacitifs en parallèle Cf et Cpga, il est également prévu un deuxième circuit capacitif commuté Cdac connecté à la masse par l'intermédiaire d'un commutateur SW5 et connecté par ailleurs également à l'entrée E1 de l'amplificateur AOP.

Par ailleurs, le deuxième circuit capacitif commuté Cdac est susceptible de recevoir une tension Vdac provenant, comme on le verra plus en détails ci-après de la sortie du circuit de conversion numérique-analogique CNA, par l'intermédiaire d'un commutateur SW6.

La figure 5 illustre la configuration des commutateurs dans la phase d'échantillonnage tandis que la figure 6, illustre la configuration dans la phase de blocage.

Sur la figure 5, les commutateurs SW2, SW3, SW5 et SW7, commandés par le signal PHi1 sont fermés tandis que les autres commutateurs SW1, SW4 et SW6 sont ouverts. En fait, dans cet exemple, le signal PHi1 correspond aux fronts montants du signal d'horloge CLK (figure 7).

Sur la figure 6, ce sont cette fois-ci les interrupteurs SW1, SW4, SW6 qui sont fermés (signal PHi2 correspondant au front descendant du signal d'horloge CLK) tandis que les autres commutateurs sont cette fois-ci ouverts.

Dans la phase d'échantillonnage, les condensateurs Cf et Cpga sont chargés par la tension d'entrée Vin tandis que le condensateur Cdac est déchargé.

Dans la phase de blocage, (figure 6) il y a transfert de charge depuis les capacités Cdac et Cpga vers le condensateur Cf.

Compte tenu des équations de transfert de charge, la tension de sortie Vout est définie par la formule (I) ci-dessous :

$$Vout = Vin.(Cf + Cpga)/Cf - Vdac.Cdac/Cf \qquad (I)$$

On voit donc que la valeur du gain de l'amplificateur est définie par le rapport (Cf+Cpga)/Cf tandis que le condensateur Cdac permet d'effectuer la soustraction de la tension Vdac dans le rapport Cdac/Cf.

En prenant une valeur capacitive nulle pour le condensateur Cpga, on obtient un gain unité.

En prenant des condensateurs Cpga et Cf de valeurs capacitives identiques, on obtient un gain égal à 2, tandis que si l'on prend un condensateur Cpga dont la valeur capacitive est égale à trois fois la valeur capacitive du condensateur Cf, on obtient un gain de 4.

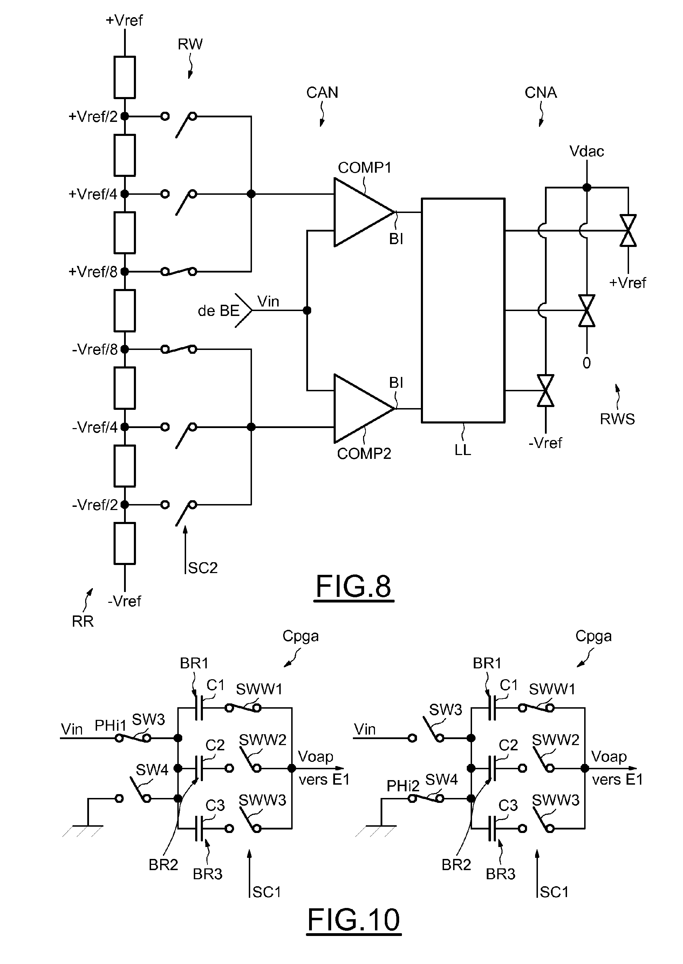

Cela étant, comme illustré sur la figure 8, le circuit de conversion analogique-numérique CAN comporte ici deux comparateurs COMP1 et COMP2, puisqu'il s'agit d'un circuit analogique-numérique 1,5 bit (donc délivrant deux bits). L'une des entrées de chaque comparateur est connectée à la borne d'entrée BE de l'étage pour recevoir la tension d'entrée Vin. Par ailleurs, les autres entrées de comparateur sont reliées à des moyens de seuillage programmable formés ici d'un réseau résistif RR couplé à une tension de référence +Vref -Vref et à plusieurs commutateurs RW sélectivement commandables par le signal de contrôle SC2.

Ainsi, en fonction du gain de l'amplificateur, on ajustera la valeur des seuils de comparaison.

Plus précisément, dans l'exemple décrit ici, pour un gain unitaire de l'amplificateur, on choisira des seuils de comparaison égaux à ± Vref/2.

Pour un gain de l'amplificateur égal à 2, on choisira des seuils de comparaison égaux à ± Vref/4 tandis que pour un gain de l'amplificateur égal à 4, on choisira des seuils de comparaison égaux à ± Vref/8.

Le circuit de conversion numérique-analogique CNA comporte trois commutateurs RWS commandables par une logique de commande LL contrôlée par la valeur des deux bits délivrés par les deux comparateurs COMP1 et COMP2. Ainsi, en fonction de la valeur de ces deux bits, la valeur de la tension Vdac sera prise égale à -Vref, 0 ou +Vref.

Plus précisément, pour des bits valant 00, c'est-à-dire pour une tension Vin inférieure à la valeur négative du seuil de comparaison, la tension Vdac sera égale à -Vref. Pour des valeurs de bit égales à 01, c'est-à-dire pour une tension Vin comprise entre la valeur négative et la valeur positive du seuil de comparaison, Vdac sera égal à 0, et pour des valeurs de bit égales à 10, c'est-à-dire pour une tension Vin supérieure à la valeur positive du seuil de comparaison, Vdac sera égal à +Vref.

Ainsi, la combinaison du gain g de l'amplificateur (défini par le rapport (Cf+Cpga)/Cf) avec le seuil correspondant permet d'obtenir un amplificateur ayant un gain global G correspondant.

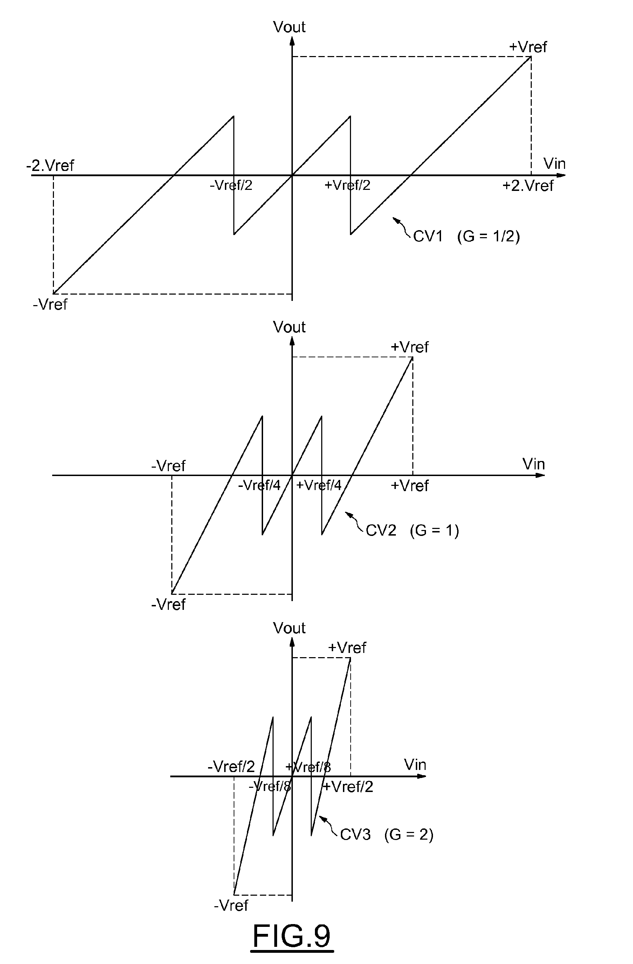

Plus précisément, dans le cas décrit ici, avec un gain g de l'amplificateur égal à 1, et des valeurs de seuil de comparaison égales à ± Vref/2, on obtient un gain global égal à ½, ce qui correspond à une atténuation de 6 dB et ce qui est illustré par la courbe CV1 de la partie haute de la figure 9.

Si le gain g de l'amplificateur est pris égal à 2 en combinaison avec des valeurs de seuil de comparaison égales à ± Vref/4, on obtient alors une amplification globale unitaire (G=1), ce qui est illustré par la courbe CV2 de la partie médiane de la figure 9.

Enfin, avec un gain g de l'amplificateur égal à 4, et des seuils de comparaison égaux à ± Vref/8, on obtient une amplification globale de gain égal à 2, ce qui est illustré par la courbe CV3 de la partie basse de la figure 9.

Dans l'exemple qui a été décrit, les valeurs capacitives des condensateurs Cdac et Cf sont égales. Et, quelle que soit la valeur du gain, on notera que la valeur Vdac est toujours prise égale à -Vref, 0 ou +Vref.

Bien entendu, si le nombre de bits délivrés par le convertisseur analogique-numérique était supérieur à 2, le nombre de valeurs de référence susceptibles d'être prises par la valeur Vdac serait plus important mais toujours indépendant du gain de l'amplificateur. Par exemple dans le cas d'un étage 2,5 bits, les valeurs susceptibles d'être prises par Vdac seraient ±3Vref, ±2Vref, ±Vref et 0.

Cela étant, dans ce cas précis, une autre façon de faire pourrait consister à garder les trois valeurs -Vref, 0, +Vref et à les délivrer sélectivement de façon indépendante au deuxième circuit capacitif commuté qui comporterait au lieu d'un seul condensateur Cdac ayant la valeur capacitive Cf, trois condensateurs ayant chacun la valeur capacitive Cf. Plus précisément dans ce cas on connecterait soit un condensateur à +Vref et les deux autres à la tension nulle (si l'on souhaite soustraire Vref), soit deux condensateurs à Vref et le troisième à la tension nulle (si l'on souhaite soustraire 2Vref), soit les trois condensateurs à Vref (si l'on souhaite soustraire 3Vref), soit un condensateur à -Vref et les deux autres à la tension nulle (si l'on souhaite additionner Vref), soit deux condensateurs à -Vref et le troisième à la tension nulle (si l'on souhaite additionner 2Vref), soit les trois condensateurs à -Vref (si l'on souhaite additionner 3Vref).

Une façon de réaliser le deuxième bloc capacitif Cpga de valeur capacitive programmable est illustrée sur la figure 10. Ce bloc capacitif est réalisé ici par plusieurs branches capacitives en parallèle BR1, BR2, BR3 (ici trois branches sont représentées puisque le gain peut être choisi entre trois valeurs différentes).

Chaque branche comporte un réseau capacitif C1, C2, C3 en série avec un commutateur commandable SWW1, SWW2, SWW3. Ces commutateurs sont commandables par le signal de contrôle SC1.

Dans l'exemple qui est décrit, la valeur capacitive de chacun des réseaux capacitifs C1, C2, C3 est égale à la valeur capacitive du condensateur Cf, ce qui permet au bloc capacitif Cpga de prendre la valeur capacitive nulle, Cf ou 3Cf, correspondant aux trois valeurs de gain envisagées.

Sur la figure 10, la valeur capacitive du bloc capacitif Cpga est égale à Cf (commutateur SWW1 fermé et commutateurs SWW2 et SWW3 ouverts).

Si l'on souhaite obtenir une valeur capacitive nulle, il convient alors d'ouvrir tous les commutateurs SWWi.

La partie gauche de la figure 10 illustre la configuration dans la phase d'échantillonnage tandis que la partie droite illustre la configuration dans la phase de blocage.

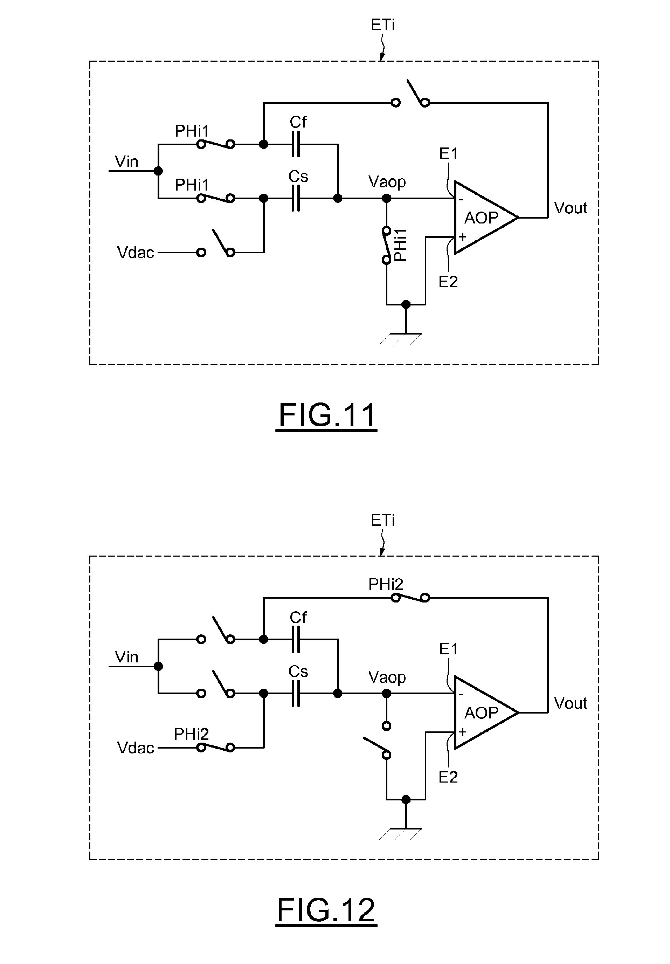

Bien qu'il soit possible de réaliser les autres étages ETi du convertisseur analogique-numérique DCAN de façon classique et connue, on peut, comme illustré sur la figure 11, utiliser une architecture similaire à celle de l'étage ET1, mais cette fois-ci avec un amplificateur à gain fixe.

Plus précisément, l'amplificateur à gain fixe comporte l'amplificateur AOP dont la sortie est rebouclée sur sa première entrée E1 par l'intermédiaire d'un premier circuit capacitif commuté auxiliaire qui comporte un premier bloc capacitif auxiliaire Cf et un deuxième bloc capacitif auxiliaire Cs. Ces deux blocs capacitifs auxiliaires ont des valeurs capacitives fixes, par exemple égales dans le cas d'un étage 1,5 bit de façon à obtenir une amplification avec un gain égal à 2.

Là encore, ce premier circuit capacitif commuté auxiliaire Cf, Cs est couplé à l'entrée de l'étage ETi. Par ailleurs, le circuit de conversion analogique-numérique est à seuil fixe, correspondant au gain de l'amplificateur à gain fixe. Ainsi, pour un gain égal à 2, on choisira des seuils égaux à $\pm$ Vref/4 conduisant à une amplification globale unitaire. Et, le circuit de conversion numérique-analogique est couplé entre la sortie du circuit analogique-numérique et le deuxième bloc capacitif auxiliaire, et plus précisément au niveau du condensateur Cs, ce qui permet là encore d'implémenter très simplement la fonction de soustraction de l'étage.

L'architecture des circuits qui ont été décrits est une architecture à entrée unique (« single ended » selon un vocable anglosaxon habituellement utilisé par l'homme du métier). Cela étant l'invention s'applique bien entendu à une architecture différentielle.

De même les trois gains globaux mentionnés ci-avant (G = ½, 1 ou 2) ne sont qu'un exemple non limitatif, l'invention pouvant se généraliser à un nombre quelconque de gains globaux, par exemple 32.

**Revendications**

1. Dispositif, comprenant un amplificateur à gain programmable et un convertisseur analogique-numérique à architecture pipeline comportant plusieurs étages, **caractérisé par le fait que** le premier étage (ET1) du convertisseur analogique-numérique (DCAN) incorpore l'amplificateur à gain programmable (AMPP) ainsi qu'un circuit de conversion analogique-numérique à seuil programmable (CAN).

2. Dispositif selon la revendication 1, dans lequel l'amplificateur à gain programmable comprend un amplificateur (AOP) dont la sortie (BS) est rebouclée sur une première entrée (E1) par l'intermédiaire d'un premier circuit capacitif commuté (Cf, Cpga) comportant un premier bloc capacitif (Cf) et un deuxième bloc capacitif (Cpga) de valeur capacitive programmable, le premier circuit capacitif commuté étant par ailleurs couplé à l'entrée dudit premier étage, et le circuit de conversion analogique-numérique à seuil programmable (CAN) est couplé à l'entrée du premier étage et comporte des moyens de seuillage programmables (RR, RW) configurés pour définir différents seuils programmables correspondants aux différents gains programmables de l'amplificateur.

3. Dispositif selon la revendication 2, dans lequel le deuxième bloc capacitif (Cpga) comporte plusieurs branches capacitives (BRi) en parallèle, chaque branche capacitive comportant un réseau capacitif (Ci) en série avec un commutateur commandable (SWWi).

4. Dispositif selon l'une des revendications 2 ou 3, dans lequel les moyens de seuillage programmables comportent un pont diviseur de tension programmable incluant un réseau résistif (RR) couplé à une tension de référence (+Vref, -Vref) et à plusieurs commutateurs sélectivement commandables (RW).

5. Dispositif selon l'une des revendications 2 à 4, dans lequel le premier étage (ET1) du convertisseur comporte en outre un circuit de conversion numérique analogique (CNA) couplé à la sortie du circuit analogique numérique (CAN) et configuré pour délivrer sélectivement une valeur de tension (Vdac) prise parmi un jeu de valeurs de référence (+Vref, 0, -Vref) indépendantes des valeurs des gains programmables, et un deuxième circuit capacitif commuté (Cdac) couplé à la sortie du circuit numérique analogique (CNA) et dont la valeur est proportionnelle à la valeur capacitive du premier bloc capacitif (Cf).

6. Dispositif selon la revendication 5, dans lequel le circuit de conversion analogique numérique (CAN) est un circuit 1,5 bit et la valeur capacitive du deuxième circuit capacitif commuté (Cdac) est égale à la valeur capacitive du premier bloc capacitif (Cf).

7. Dispositif selon l'une des revendications précédentes, comprenant en outre des moyens de contrôle (AGC), externes au convertisseur analogique-numérique (DCAN), et configurés pour délivrer des signaux de contrôle (SC1, SC2) destinés à programmer une valeur de gain et une valeur de seuil.

8. Dispositif selon l'une des revendications précédentes, dans lequel chaque autre étage (ETi) du convertisseur comporte un amplificateur à gain fixe comprenant un amplificateur (AOP) dont la sortie est rebouclée sur une première entrée (E1) par l'intermédiaire d'un premier circuit capacitif commuté auxiliaire (Cf, Cs) comportant un premier bloc capacitif auxiliaire (Cf) et un deuxième bloc capacitif auxiliaire (Cs) de valeurs capacitives fixes, le premier circuit capacitif commuté auxiliaire étant par ailleurs couplé à l'entrée dudit autre étage, un circuit de conversion analogique numérique (CAN) à seuils fixes correspondant au gain de l'amplificateur à gain fixe, et un circuit de conversion numérique analogique (CNA) couplé entre la sortie du circuit analogique numérique et le deuxième bloc capacitif auxiliaire (Cs).

**9.** Procédé de traitement d'un signal analogique comprenant une amplification à gain programmable et une conversion analogique numérique du signal au sein d'un convertisseur analogique-numérique à architecture pipeline comportant plusieurs étages, **caractérisé en ce que** chaque étage est cadencé au rythme d'un signal d'horloge (CLK), et à l'intérieur de chaque période du signal d'horloge (CLK) on effectue au sein du premier étage l'amplification et la quantification du signal.

**10.** Procédé selon la revendication 9, dans lequel la quantification et l'amplification/attenuation effectuées au sein dudit premier étage sont programmables par des valeurs de gain et de seuil programmées par des signaux de contrôles externes au convertisseur analogique-numérique et obtenues à partir du signal de sortie du convertisseur analogique-numérique.

DCANPA

BCR

MNS

Correction numérique

SAE

Etage 1    Etage 2    ----    Etage N

SM

S/H

CAN    CNA

b bits

g

AMP

## FIG.1
## art antérieur

Vin

PGA

Vin'

DCANPA

n Bits

p Bits

AGC

## FIG.2
## art antérieur

## FIG.3

## FIG.4

FIG.5

FIG.6

FIG.7

## FIG.8

## FIG.10

Vout

+Vref

-2.Vref                    Vin
      -Vref/2   +Vref/2   +2.Vref

CV1   (G = 1/2)

-Vref

Vout

+Vref

-Vref                    Vin
      -Vref/4  +Vref/4   +Vref

CV2   (G = 1)

-Vref

Vout

+Vref

-Vref/2   +Vref/8   Vin
      -Vref/8   +Vref/2

CV3   (G = 2)

-Vref

## FIG.9

ETi

## FIG.11

ETi

## FIG.12

# EP 2 216 906 A1

**Europäisches Patentamt**
**European Patent Office**
**Office européen des brevets**

## RAPPORT DE RECHERCHE EUROPEENNE

Numéro de la demande

EP 10 15 2991

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2005/062635 A1 (FRANZ BERND [DE]) 24 mars 2005 (2005-03-24) | 9-10 | INV.<br>H03M1/16<br>H03M1/18 |
| Y | * page 1, alinéa 8-10; figure 1 *<br>* page 1, alinéa 15 - page 2, alinéa 17 *<br>* page 3, alinéa 33; revendications 1, 6 *<br>----- | 1-7 | |
| Y | US 6 590 517 B1 (SWANSON ERIC J [US]) 8 juillet 2003 (2003-07-08)<br>* colonne 3, ligne 9-23; figures 2, 3, 11 *<br>* colonne 4, ligne 20 - colonne 17, ligne 57 *<br>* colonne 26, ligne 35 - colonne 32, ligne 13 *<br>----- | 1-4,7 | |
| Y | KANG S G; LEE H C; WOO D H: "Multiple Integration Method for a High Signal-to-Noise Ratio Readout Integrated Circuit"<br>IEEE TRANSACTIONS ON CIRCUITS AND SYSTEMS II: EXPRESS BRIEFS, IEEE SERVICE CENTER, NEW YORK, NY, US,<br>vol. 52, no. 9,<br>1 septembre 2005 (2005-09-01), pages 553-557, XP011139257<br>ISSN: 1057-7130<br>* figures 5, 6 *<br>-----<br>-/-- | 5 | |

| | | | DOMAINES TECHNIQUES RECHERCHES (IPC) |
|---|---|---|---|
| | | | H03M |

Le présent rapport a été établi pour toutes les revendications

| Lieu de la recherche | Date d'achèvement de la recherche | Examinateur |
|---|---|---|
| Munich | 5 mars 2010 | Brosa, Anna-Maria |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................

& : membre de la même famille, document correspondant

EPO FORM 1503 03.82 (P04C02)

14

Europäisches
Patentamt

European
Patent Office

Office européen
des brevets

# RAPPORT DE RECHERCHE EUROPEENNE

Numéro de la demande

EP 10 15 2991

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | YONG LUO; MOSKALEV A; BAYS L E; PETRYNA B J: "A High linearity analog front end for multiprocessor SOC integration" SYSTEM-ON-CHIP, 2004. PROCEEDINGS. 2004 INTERNATIONAL SYMPOSIUM ON TAMPERE, FINLAND NOV. 16-18, 2004, 20041116 - 20041118 PISCATAWAY, NJ, USA,IEEE, 16 novembre 2004 (2004-11-16), pages 9-12, XP010777944 * page 10, colonne de gauche, alinéa 2 - page 10, colonne de droite, alinéa 3; figure 3 * ----- | 6 | |
| Y | US 7 295 645 B1 (EL-GHOROURY HUSSEIN S [US]; KARSI MURAT F [US]) 13 novembre 2007 (2007-11-13) * le document en entier * ----- | 1,7 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 5 mars 2010 | Brosa, Anna-Maria |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 15 2991

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-03-2010

| Document brevet cité au rapport de recherche | | Date de publication | Membre(s) de la famille de brevet(s) | | Date de publication |
|---|---|---|---|---|---|
| US 2005062635 | A1 | 24-03-2005 | AT<br>DE<br>DE<br>EP | 311041 T<br>60302468 D1<br>60302468 T2<br>1521370 A1 | 15-12-2005<br>29-12-2005<br>08-06-2006<br>06-04-2005 |
| US 6590517 | B1 | 08-07-2003 | AUCUN | | |
| US 7295645 | B1 | 13-11-2007 | AUCUN | | |

EPO FORM P0460

Pour tout renseignement concernant cette annexe : voir Journal Officiel de l'Office européen des brevets, No.12/82